# EUROPEAN PATENT APPLICATION

(11) **EP 4 274 391 A1**
(43) Date of publication of application: **08.11.2023**
(21) Application number: 22172145.9
(22) Date of filing: 06.05.2022
(51) Int. Cl.: H05K 1/09, H05K 3/12

(54) **METHOD FOR MANUFACTURING AN ELECTRICALLY CONDUCTIVE METAL TRACE AND CORRESPONDING METAL TRACE, PARTICULARLY SUITABLE FOR TRANSIENT ELECTRONIC DEVICES**

(71) Applicant: ECOLE POLYTECHNIQUE FEDERALE DE LAUSANNE (EPFL), 1015 Lausanne (CH)
(72) Inventor: FUMEAUX, Nicolas, 1982 Euseigne (CH); BOURELY, James, 2000 Neuchatel (CH); BRIAND, Danick, 2065 Savagnier (CH)
(74) Representative: M. Zardi & Co S.A.

(57) **Abstract**

It is disclosed a method for manufacturing an electrically conductive metal trace (1) comprising depositing metal micro or nano particles (2) in or on a substrate (3); removing an oxide layer (4) around the particles; sintering the particles after oxide layer removal to form the electrically conductive metal trace (1). The method is characterized in that the step of removing the oxide layer is an electrochemical process wherein the metal micro or nano particles are contacted by a reducing agent (5), and the step of sintering is heat sintering induced by light (6). The method is particularly suitable for manufacturing a transient electrically conductive metal trace.

## Description

### Field of application

The present invention relates to a method for manufacturing an electrically conductive metal trace, in particular a transient electrically conductive metal trace, such as a biodegradable trace suitable to degrade into benign products in the environment or a bioresorbable trace suitable to degrade into benign products in the human body. More particularly, the present invention relates to a method of the type cited above wherein metal micro or nano particles are deposited in or on a substrate, and subsequently sintered to form the metal trace.

The present invention is also referred to the electrically conductive metal trace manufactured through the method mentioned above, and to a device including such metal trace(s).

### Prior art

It is known in the art manufacturing metallic traces (or tracks) for electronics, for instance printing metal particles and sintering them to make conductive traces. In particular for sintering, one method is usually applied among
a) an electrochemical method, wherein use of chemicals is made to remove an oxide layer around the particles and to fuse them together or
b) a photonic method wherein light, for instance laser or pulsed-light photonic sintering or near-infrared lamp sintering, is used for local heating and melting of the particles.

Here below, known techniques are briefly cited. These techniques are generally adopted when the electrically conductive metal trace to be manufactured has to be biodegradable or bioresorbable, however with drawbacks which are also briefly commented here below.

According to a known process (1: Feng, Shuxuan, et al. "Maskless patterning of biodegradable conductors by selective laser sintering of microparticle inks and its application in flexible transient electronics." ACS applied materials & interfaces 11.49 (2019): 45844-45852), laser sintering locally melts a layer of zinc microparticles previously deposited on a substrate. This process is applicable on layers with thickness of more than 50 microns, whereas it is destructive on thinner layers. With this technique, the top part of the layer is melted while the bottom part of at least 30 microns serves as buffer; moreover, the technique is less suitable for fast large-scale treatment.

According to another process (2: Lee, Yoon Kyeung, et al. "Room temperature electrochemical sintering of Zn microparticles and its use in printable conducting inks for bioresorbable electronics." Advanced Materials 29.38 (2017): 1702665), an acetic acid solution is drop-cast on Zn traces and reacts with zinc oxide to convert it to metallic zinc, which redeposits and form conductive bridges between the particles. The conductivity of traces obtained with this process is lower than that obtained with photonic sintering mentioned in (1) and the stability of conductivity over time is limited. Moreover, drop casting has been shown to modify the unsintered metal trace resolution due to the high amount of liquid in contact with it, causing partial dissolution.

In another process (3: Li, Jiameng, et al. "Anhydride-Assisted Spontaneous Room Temperature Sintering of Printed Bioresorbable Electronics." Advanced Functional Materials 30.29 (2020): 1905024), a propionic anhydride solution is used, which then reacts with water in the air to form propionic acid. This technique, which is similar to that mentioned at (2) suffers indeed from the same limitations in terms of conductivity and stability.

According to another known process (4: Mahajan, Bikram K., et al. "Mechanically milled irregular zinc nanoparticles for printable bioresorbable electronics." Small 13.17 (2017): 1700065), micrometer-sized particles of zinc are milled in nanoparticles, which are then sintered by photonic sintering. In this case, oxide layer remains on the particles and negatively affects sintering. Moreover, high energies are required, which may cause substrate damages. Other techniques (5: Mahajan, Bikram Kishore, et al. "Aerosol printing and photonic sintering of bioresorbable zinc nanoparticle ink for transient electronics manufacturing." Science China Information Sciences 61.6 (2018): 1-10) similar to the one cited at (4), uses a different deposition method (aerosol jet printing), as to energies requirement and substrate damages, are affected by same limitations.

In further known methods (6: Shou, Wan, et al. "Low-cost manufacturing of bioresorbable conductors by evaporation-condensation-mediated laser printing and sintering of Zn nanoparticles." Advanced Materials 29.26 (2017): 1700172), a glass slide is used as a target substrate for the zinc deposition, which is than evaporated onto the target substrate through a laser. The process may end in a metal trace of good quality but it is highly challenging as to scale and involves several manual steps as in part of the processes mentioned above.

Sintering processes (7: Majee, Subimal, et al. "Low temperature chemical sintering of inkjet-printed Zn nanoparticles for highly conductive flexible electronic components." npj Flexible Electronics 5.1 (2021)) as the one cited in (2), i.e. drop casting, adopt an ink suitable for inkjet printing, to deposit thinner layers and to obtain higher resolution. However, it also suffers from the same limitations as those cited in connection with process (2).

Further attempts have been made to provide processes of the type disclosed at (2), i.e., drop casting, with additional curing steps, which however do not solve the limitation mentioned in connection with drop casting process (2). This is for instance the case of (8: Rogers, John A., and Xian Huang. "Biodegradable materials for multilayer transient printed circuit boards." U.S. Patent No. 10,292,263. 14 May 2019).

Further different methods (9: Rogers John A; Kang Seung-Kyun; Hwang Sukwon; Cheng Jianjun; Zhang Yanfeng; Ying Hanze. "Transient electronic devices comprising inorganic or hybrid inorganic and organic substrates and encapsulates" US2014305900A1 16 October 2014) of fabrication of transient electronic devices incorporating degradable components, substrate and/or encapsulation materials different than those cited above or methods (10: Casasanta Vincenzo, "Biodegradable printed circuit boards and methods for making the printed circuit boards". US2017006701A1, Empire Technology DEV LLC, 5 January 2017) of fabrication of biodegradable printed circuit board devices using biodegradable printed circuit substrates have been disclosed, however not solving the above drawbacks cited in connection with method from (1) to (8).

At last, in some methods (11: Chen Min; Yu Xinge. "Biodegradable electronic material for printed electronic technology" CN111574885A, Chengdu Huaici Fuyou Electronic Tech co LTC, 25 August 2020), zinc is used as a biodegradable conductive layer for printed electronics and in other (12: Schroder Kurt A; Uchida Hiroshi; Shinozaki Kenji Substrate film and sintering method KR20190075151A, Showa Denko KK, 26 June 2019), photonic sintering is disclosed to cure a metallic layer such as zinc. However, also the material (zinc) and the curing (photonic sintering method) as disclosed in these last methods present some drawbacks, for instance due to the fact that conductivity of the metal trace is not sufficient for certain applications such as high frequency and wireless communication.

The technical problem at the base of the present invention is that of providing a method of manufacturing an electrically conductive metal trace or (track), in particular (but not necessarily) for manufacturing metal traces in or on a substrate of biocompatible and/or bioresorbable material, which is suitable to be reproduced on a large scale, avoiding drop casting, which may have an effect on the resolution of the unsintered metal trace, at the same time suitable to overcome the limit in thickness of the metal traces produced with other known processes, and to improve the conductivity of the metal traces, the strength thereof, while limiting the quantity of energy used for manufacturing, and without stressing the trace or the substrate, in other words solving all the drawbacks that currently affects the known methods.

### Summary of the invention

The idea of solution of the present invention is to manufacture an electrically conductive metal trace on a substrate, in particular (but not exclusively) a metal trace in or on a biocompatible and/or bioresorbable substrate, wherein two specific and different stages are subsequently applied on microparticles or nanoparticles of the metal:
a first stage for removing an oxide layer around the particles and
a second stage for sintering the particles after said oxide layer removal,
wherein said first stage is made by an electrochemical process and said second stage is made by a heat sintering induced by light.

These stages in sequence are suitable for reproduction on large scales, they avoid manual steps as those involved in drop casting, are applicable to a substrate with limited thickness and temperature resistance without damaging it and to produce as well metal traces with limited thickness and width, at the same time significantly improving the conductivity of the metal traces, the strength thereof, while providing a process speed that is compatible with high-throughput industrial production.

The first stage of removing the oxide layer, according to different aspects of the present invention, is carried out before, during or after deposition of microparticles or nanoparticles of the metal.

A diameter of the particles is in the range between 10 nm to 100 um on average and, preferably, in the range between 10 nm and 10 um.

Said timing (before, during or after deposition) for carrying out the first stage of removing the oxide layer may be selected (or depend), among other and in some non-limiting embodiments, on the features of a medium M1 including the microparticles or nanoparticles and/or the features of a medium M2 including a reducing agent and/or the method used for their delivery (when medium M1 and medium M2 are mixed together or when they are deposited in or on the substrate).

For instance, medium M1 and medium M2 may be suitable to be mixed before starting deposition, in which case the first stage of removing the oxide layer may start before the deposition of the microparticles or nanoparticles in or on the substrate is started. In this case, the first stage of removing the oxide may potentially complete even before the deposition of microparticles or nanoparticles in or on the substrate is started. However, the first stage of removing the oxide may start before and complete after deposition in or on the substrate. The above may be the case where the reducing agent is mixed with an ink and the electrochemical reduction process starts as the ink/agent composition is formulated.

On the other hand, medium M1 and medium M2 may be stored separately and mixed together as part of the step of deposition in or on the substrate, meaning that two separate flows of microparticles or nanoparticles and reducing agent join together while depositing, and start reacting as soon as they join.

Furthermore, deposition of microparticles or nanoparticles can precede the first stage of removing the oxide layer, meaning that the reducing agent is delivered after the microparticles or nanoparticles have been already incorporated and/or deposited onto the substrate.

The selection of methods for oxide removal and sintering, and their sequence of application on the microparticles or nanoparticles previously deposited on the substrate, especially when deposition is made by printing, according to embodiments thereafter disclosed, have several advantages which will be clear by the description provided below and overcome the drawbacks mentioned in connection with the prior art.

Based on the idea of solution mentioned above, the technical problem is solved by a method for manufacturing an electrically conductive metal trace according to the present invention, comprising:
- depositing metal micro or nano particles in or on a substrate;
- removing an oxide layer around the particles;
- sintering the particles after oxide layer removal;
wherein
- removing the oxide layer is made by an electrochemical process in which a reducing agent is put in physical contact with the metal micro or nano particles and sintering is a heat sintering induced by light.

In particular, the step of depositing metal micro or nano particles in or on a substrate and the step of removing an oxide layer around the particles may be sequential or contemporary.

When sequential, the step of depositing may occur before, during and/or after the step of removing the oxide layer.

According to an aspect of the disclosure, the micro or nanoparticles are included in a paste, ink or slurry. Depositing the metal micro or nano particles is made, for instance, by stencil printing or screen printing or direct ink writing or inkjet printing or aerosol jet printing or spin-coating or slot-die coating or drop-coating or doctor blade casting. Other deposition technique may be used as well. The method for deposition is selected based on the thickness of the metal trace to be manufactured.

Preferably, the paste, ink or slurry includes a solvent, a polymeric binder and/or a dispersant, along with the micro or nanoparticles. The metal includes for instance zinc or iron or tungsten or molybdenum or magnesium or an alloy thereof. Preferably, the metal is a bioresorbable or biodegradable metal. The substrate includes for instance one of: Poly(vinyl acetate), Polylactic acid or paper, cellulose-derived, polysaccharides, synthetic polymers, PCL, sodium carboxymethyl cellulose (Na-CMC), poly(ethylene) oxide (PEO), polylactic acid (PLA), polyglycolic acid (PGA), polylactic-co-glycolic acid (PLGA), silk, poly(glycerol-sebacate) (PGS). Other substrates may be adopted. Also the substrate is preferably biocompatible and/or bioresorbable.

The process of sintering includes for instance photonic sintering, flash sintering, intense pulsed light sintering, laser sintering or near-infrared lamp sintering.

As to the electrochemical process, the reducing agent may be applied according to different techniques. In one aspect, the reducing agent is applied on the paste, ink or slurry after deposition of the paste, ink or slurry.

In another aspect, the paste, ink or slurry is a two-components paste, ink or slurry and the two components of the paste, ink or slurry are mixed at the time of deposition.

According to another aspect, the reducing agent is applied by spraying. The reducing agent is for instance an acetic acid solution or a formic acid solution or a propionic acid solution.

Preferably, the particles are dried after spraying. Drying includes flowing air, and/or flowing an inert gas and/or heating at a temperature between 20° and 200°, preferably between 25° and 60°. Preferably flowing and/or heating is made under an inert gas atmosphere.

The technical problem mentioned above is also solved by an improved electrically conductive metal trace obtained by the method of the present invention. The metal trace is used as the trace of a passive or active component or of a system including the passive and active components. For instance, the passive component is at least one selected from the group consisting of resistors, capacitors, inductors.

The method in particular is suitable for producing metal traces for transient electronics. Transient electronics refer to devices that can degrade into benign byproducts in the environment (biodegradable) or the human body (bioresorbable).

As used herein, a "biodegradable material" also refers to a material manufactured of polymer, copolymer or polymer composition, the degradation and/or absorbing of which material takes place by means of metabolic, chemical and/or physical reactions. The degradant component may increase the rate of degradation of the polymer by a process that involves one or more of, for example, photodegradation, biodegradation, or chemical degradation.

In addition, mechanical forces such as erosion may further help degrade the polymer. Photodegradation means a process of degradation that is initiated by exposure of the polymer to natural or artificial light. Biodegradation means a process of degradation that occurs as a result of the action of enzymes, derived from the metabolic processes of a subject, on the polymer. Chemical degradation means a process of degradation wherein chemical bonds in the polymer are broken as a result of one or more chemical reactions such as, for example, hydrolysis, thermal cleavage, or oxidation. Chemical degradation is thus more encompassing than photodegradation, since the reactions are not limited to those initiated by exposure to light. It is possible that a given mechanism of degradation may be classified as more than one of the above-described processes. Non-limiting, exemplary degradation mechanisms comprise UV light, liquid uptake, temperature change, application of a magnetic or electric field, pH change, pressure change and/or ionic strength change.

The term "degradation" encompasses either a full degradation, in which the material is totally degraded so that it disappears, or a partial degradation which alters the chemical and/or physical properties of the degraded material, such as the Young's modulus or the density of the degraded material, while keeping the material in place. In this context, for the sake of clarity, in the frame of the present disclosure a "partial degradation" can also be called "softening". Of note, a partial degradation or softening can be, in some embodiments, reversible, such as for instance in the case of removal or reversal of the degrading conditions. Further, a degradation process can be complete such that the entirety of the material is affected by the degradation process, or uncomplete, such that only a fraction of the material is degraded, such as about the 50, 60, 70, 80, 90, 95 or 99% of the volume and/or the weight of the material.

Within the meaning of the present invention degradable material includes also "fast-degradable material", meaning degradable material that can be degraded by one or more of the above-listed degradation mechanisms, completely or partially, in a time lapse comprised between 1 minute and 1 week, such as for instance 2, 3, 4, 5, 6 or 7 days, as well as in a time lapse comprised between 10 minutes to 24 hours, such as for instance between 15 and 60 minutes, or between 30 and 120 minutes.

Advantageously, the metal trace(s) produced by the method of the present invention may be basic elements included in an active or passive component, in a PCB or more generally in an electronic device, hereafter indicated for ease of explanation as a transient component. The term "component" is not limiting the functionality of the electronic device, meaning that the transient component also includes transient devices providing a full functionality, without the need of further additional component, to cite some a temperature or pressure sensor.

The transient component includes the substrate and one or more metal traces supported by the substrate. In one embodiment, at least one pad is also included in the transient component for receiving a lead from another electronic component which, in its turn, may be a transient component. However, nothing prevents, according to other embodiments, that the entirety of the metal trace is encapsulated or has no pad, and interfacing thereof is made wirelessly.

An encapsulating material may at least partially encapsulate one or more metal traces, wherein the encapsulating material may comprise a selectively transformable material that is at least partially removed in response to an external or internal stimulus. The encapsulating material may be the same material forming the substrate, for instance Poly(vinyl acetate), Polylactic acid or paper, cellulose-derived, polysaccharides, synthetic polymers, biopolymers, Si, glass, polyhydroxyalkanoates, polyesters, polyanhydrides, beeswax PCL, sodium carboxymethyl cellulose (Na-CMC), poly(ethylene) oxide (PEO), polylactic acid (PLA), polyglycolic acid (PGA), polylactic-co-glycolic acid (PLGA), silk, poly(glycerol-sebacate) (PGS).

The substrate and/or the metal traces includes transformable material and are suitable to undergo a transformation upon application of an internal or external stimulus. The transformation is for instance dissolution or biodegradation to benign end products or a change from a first functionally operable state to a second functionally inoperable state, wherein the transformable material undergoes the transformation at a preselected rate. According to an aspect, the transformable material is stable in the absence of an internal or external stimulus for a predetermined period, for instance for a period of days (to cite an example for less than a week). Upon exposure to the internal or external stimulus, the transformable material is completely transformed. Transformation may take a period of days (for instance a period of days, such as less than a week). Different periods may be addressed by different transient or transformation materials.

In one aspect of the disclosure, the transient component is in the form of a PCB. A plurality of transient PCBs may be laminated together in a multilayer structure. The transient PCB may further include a (transient) electronic component selected from the group consisting of a resistor, a capacitor, a diode, an inductor, a sensor, a silicon chip, an actuator, an antenna, a coil or an electromagnetic shielding layer. The transient PCB may further include a receiver/actuator which is responsive to a trigger initiated externally by a user. Upon a trigger receipt, the transient PCB, which is operationally connected to the receiver/actuator, directly or indirectly initiates at least a partial transformation of the transformable material, thereby providing a programmable transformation in response to the external trigger signal. Programmable transformation provides a change in function of the transient PCB from a first condition to a second condition.

The (transient) component may be an energy harvesting structure, a near-field communication (NFC) device, a radio-frequency identification (RFID) device, an energy storage device, a chemical/biological or physical sensor, a photosensitive element or a combination thereof. Although the structure or multi-structures of the metal traces of the present disclosure, and the combination or arrangement thereof in a more complex transient component are substantially countless, due to the reactivity of the possible material used, they are often not compatible with processes that involve high temperature or harsh chemicals, making them challenging to pattern with conventional semiconductor fabrication methods. According to the present disclosure, deposition, reduction and sintering processes are suitable to prevent damages or undesired reactions.

As to deposition, printing techniques for deposition address this challenge, and provide further advantages in terms of manufacturing of large-area electronics or on temperature-sensitive substrates. Moreover, according to the method disclosed in the present application, combined use of the electrochemical process and heat sintering induced by light has been surprisingly found to offer conductivity in the metal traces which is more than one order of magnitude higher than electrochemical sintering methods as known, and still superior to other light-based techniques. The combined use of the electrochemical process and heat sintering induced by light is also said hybrid approach since taking advantages from different techniques.

Compared to the prior art methods, for instance laser sintering, the hybrid approach of the present application offers advantages in terms of rapidity and scalability, as well as reduced damage to the substrate. Moreover, a higher level of particle fusion is obtained by combining the electrochemical process and the heat sintering induced by light in the sequence and grants the metallic layer higher durability (less relative decrease of conductivity with time) with respect to electrochemically sintered zinc for instance.

The conductivity of metal traces is even superior to some oven-sintered commercial silver inks which are used for instance for RFID tags and solar panels. This high conductivity is particularly surprising as the conductivity of most transient metals is roughly four times lower than this of bulk silver.

According to a preferred embodiment of the invention, which is suitable to further improve reliability and replicability, the electrochemical process and the heat sintering induced by light have been specifically selected by the applicant. In particular, as to the electrochemical process, according to an embodiment as disclosed, application of an acidic solution to printed metal (for instance, but not exclusively) zinc layers in order to remove the oxide layer have been selected. In an embodiment, the application involves spray coating of the acidic solution, followed by rapid (a few minutes) drying with either nitrogen flow or low heat (temperature from 0 to 60°C).

The stability in terms of conductivity of the electric tracks has been characterized by the applicant in air and water (with a degradable encapsulation in the case of tests in water) and their performance has been tested to be maintained for a sufficient period of time to be applicable to the emerging field of degradable electronics.

Advantageously, the hybrid approach based on the electrochemical process and the (photonic) sintering may be applied on temperature-sensitive substrates with limited substrate exposure to high temperatures with respect to prior art methods, to achieve sintering of metal micro and nanoparticles.

The metal ink is amenable to various deposition methods, from large area techniques such as screen printing to digital additive manufacturing processes such as direct ink writing. The oxide layer around the particles, which impedes conductivity, is reduced using a reduction agent, which is applied to the layer. After removal of the oxide layer, agglomeration of the particles into a continuous layer is achieved by heat sintering induced by light, for instance with the application of high-intensity light pulses to the sample. This combination of reducing agent and heat sintering by light has shown to be compatible with temperature-sensitive polymeric and cellulosic substrates used in standard and biodegradable printed electronics. The conductivity which is obtained in the metallic layer is the highest in the current state of the art and the traces are shown to be robust, durable (i.e. electrically stable over time) and flexible, as well as suitable for the fabrication of electrically conductive tracks (Printed Circuit Board (PCB)), interconnects, antennas, electrodes, transducers, and sensors. The method as disclosed in the present invention therefore allows to improve conductivity of metal traces, to reduce loss of conductivity rate, to reduce thickness and width, grain or particle size, sintering depth, reducing intensity used in lamp, it is applicable for manufacturing biodegradable electronics (e.g. mass loss rate, degradation mechanism) and to achieve durability of traces in air.

### Brief description of the drawings

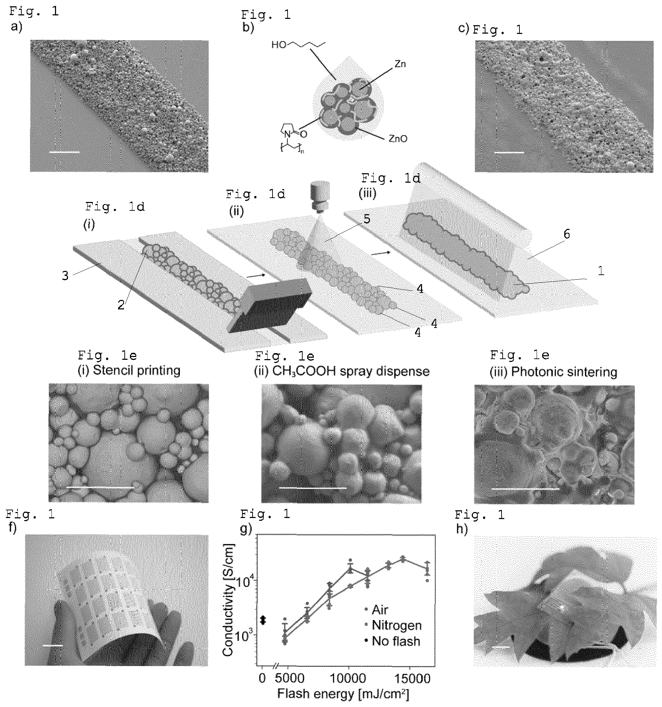

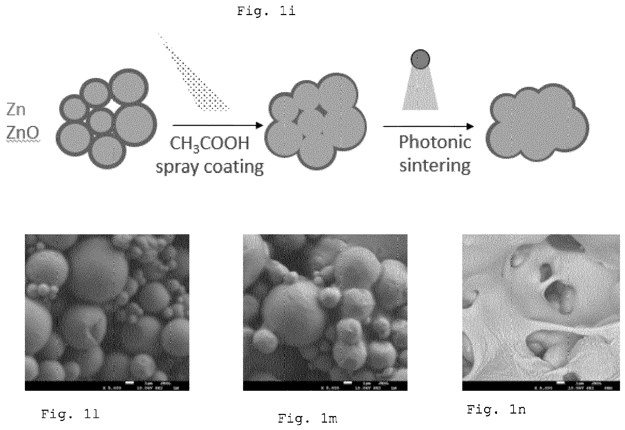

Figures 1a-1c represent the hybrid zinc sintering process as disclosed in the present application and in particular:
fig.1a) represents a screen-printed Zn line (trace) after solvent evaporation,
fig.1b) represents a printable ink composition in a schematic and magnified view,
fig.1c) represents the screen-printed Zn line after the two-step sintering process.
Figure 1d(i)-(iii) are schematic representations of the steps of the hybrid approach according to an embodiment as disclosed in the present application, wherein
fig.1d(i) represents the deposition by printing,
fig.1d(ii) represents acetic acid spray coating and
fig.1d(iii) represents photonic sintering.
Fig. 1e(i)-(iii) represents the Microstructure of the Zn by SEM after each processing step of fig. 1d(i)-(iii).
Fig. 1f) is an example of a printed Zn resistors on cellulosic substrate.
Fig. 1g) is a diagram of the measured conductivity of Zn traces at different pulse energy and under air or nitrogen atmosphere.
Fig. 1h) is a picture of a wirelessly powered LED circuit based on a Zn secondary coil on a degradable substrate as disclosed in the present application.
Fig. 1i) is a schematic representation of the main steps of the method according to an embodiment of the present invention;
Fig. 1l)-1m) are pictures of the particles, respectively, after deposition, after application removal of oxide layer and after heat sintering by light induced by light according to an embodiment of the present invention.
Figure 2a-2b are diagrams concerning the study of the sintering process on an inert substrate (polyimide), in particular:

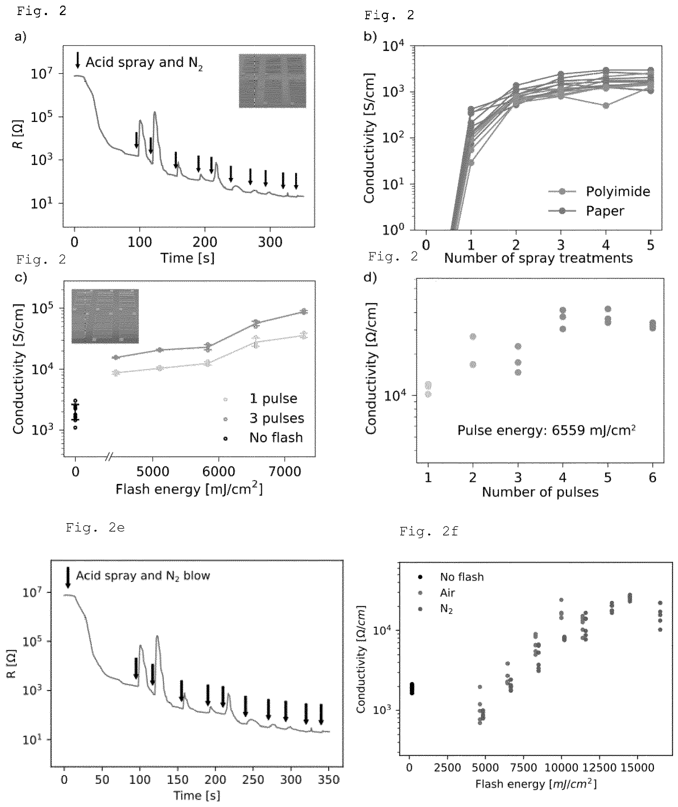

Fig.2a) Real-time measure of the resistance of a Zn line under subsequent acetic acid spray coatings and nitrogen drying;
Fig.2b) Conductivity of Zn resistors on polyimide and paper after electrochemical treatment cycles;
Fig. 2c) Conductivities of Zn resistors treated with electrochemical and photonic sintering, for 1 and 3 pulses of various energies;
Fig. 2d) Influence of the numbers of pulses on the conductivity of sintered zinc for one pulse energy.
Fig. 2e) and 2f are views in different scale of, respectively, fig. 2a) and 2d).

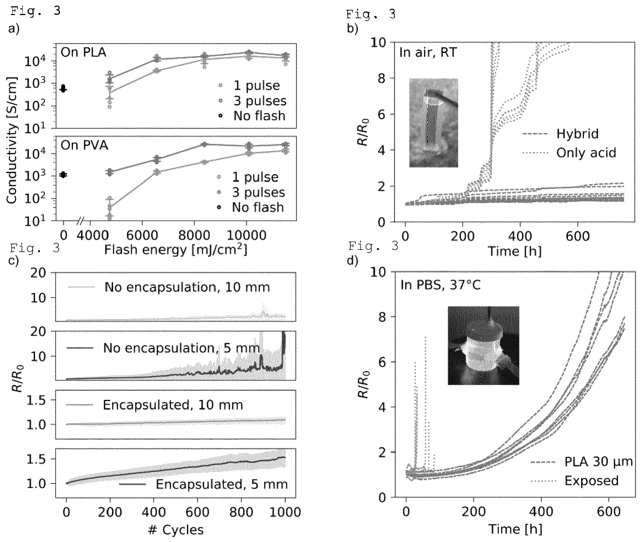

Figures 3a-3d are diagrams concerning the sintering of Zn on transient substrates and durability of the traces, in particular:
Fig. 3a) is a diagram representing Conductivity for sintered Zn traces as a function of flash energy and number of pulses, on PVA and PLA;
Fig.3b) is a diagram representing evolution of the resistance for unencapsulated Zn samples stored at ambient conditions, as a function of the sintering protocol;
Fig.3c) is a diagram representing a change in resistance for sintered Zn lines on PLA, for radii of 5mm and 10mm, with and without PLA encapsulation;
Fig.3d) is a diagram representing an evolution of the resistance for encapsulated and unencapsulated sintered Zn lines in phosphate-buffered saline (PBS) at 37°C.

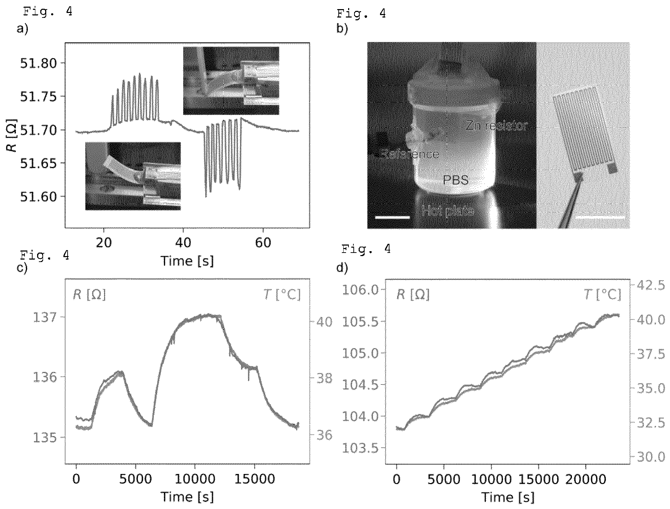

Figures 4 are diagrams concerning the Transient resistive sensors fabricated with printed Zn encapsulated in PLA, in particular
Fig.4a) Zn resistor used as a strain sensor in compression and tension (insets);
Fig. 4b) Zn resistor used as temperature sensor in a vial of PBS, with a reference temperature sensor;
Fig.4c) Zn resistance change with an arbitrary change in PBS temperature around physiological temperatures;
Fig. 4d) Zn resistance change following an increasing temperature in PBS.

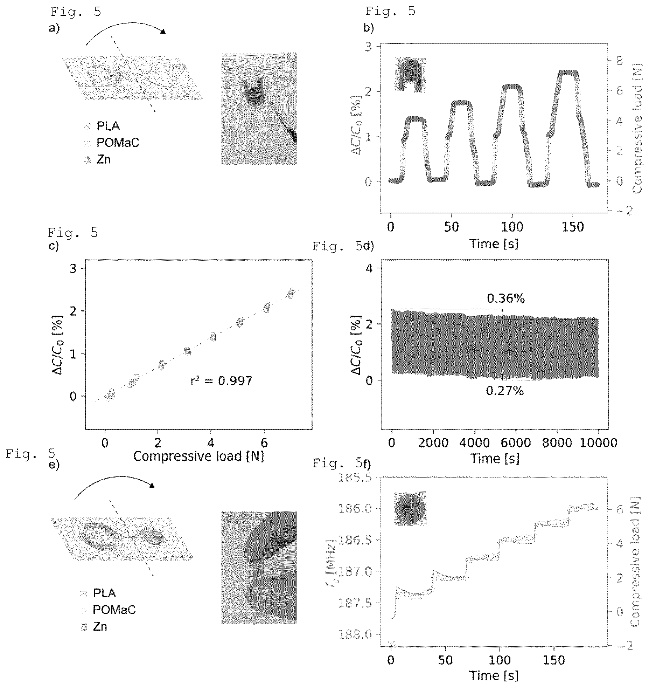

Figures 5 are diagrams concerning Bioresorbable capacitive sensors based on zinc sintering and soft elastomer POMaC, in particular:
Fig.5a) Schematic of the Zn-POMaC capacitor and picture of the sensor;
Fig.5b) Response of a pressure sensor in relative capacitance change under compressive load;
Fig.5c) Relative change in capacitance over 10 cycles for forces up to 7 N;
Fig.5d) Cycling of a capacitive sensor for 10000 s (each cycle represents 40 s).
Fig.5e) Schematic of the Zn based RLC circuit and picture of the sensor;
Fig.5f) Response of a wireless pressure sensor in resonant frequency change under compressive load.

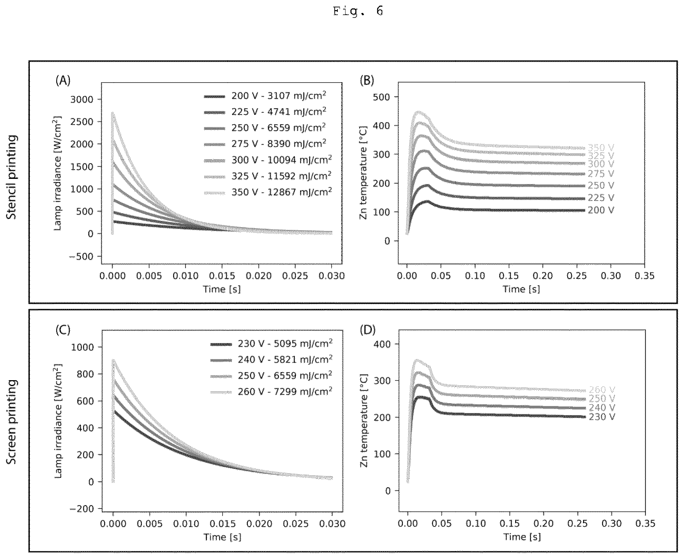

Figure 6 are diagrams of pulses delivered by the PulseForge 1200 photonic sintering lamp and simulation of the temperature in the metal layer upon application of the light pulse, in particular:
   - pulse as a function of lamp voltage used for stencil and screen-printed patterns is represented respectively in diagram (A) and (C);
   the simulated temperature in the metal layer for stencil and screen printing is represented, respectively, in diagrams (B) and (D).

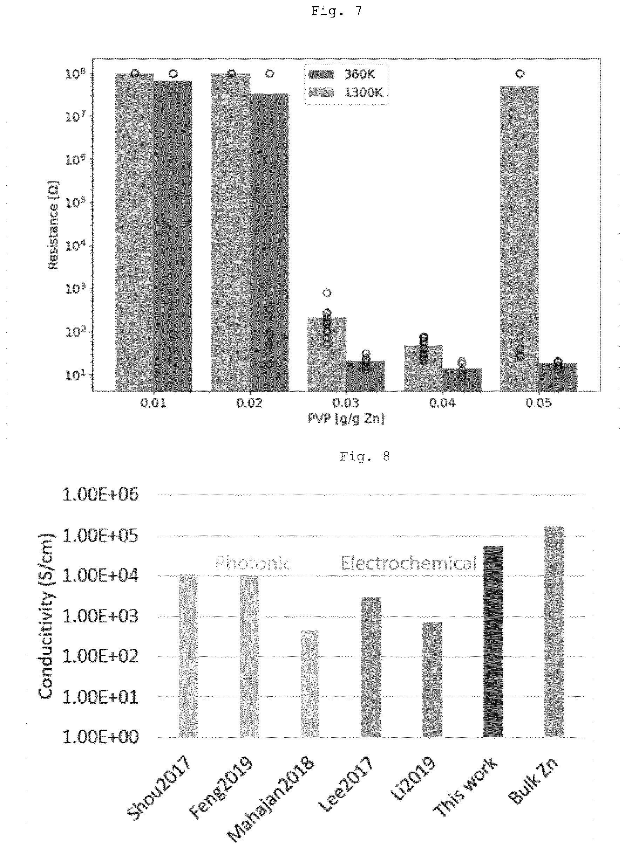

Figure 7: is a diagram representing the resistance of lines (traces) treated by electrochemical acetic acid sintering as a function of the concentration of PVP per amount of Zn in the solution.
Figure 8: is an example from the literature of conductivity values obtained for printed zinc for different methods, compared to the conductivities for Zn sintering and bulk Zn, according to a hybrid approach of the present invention.

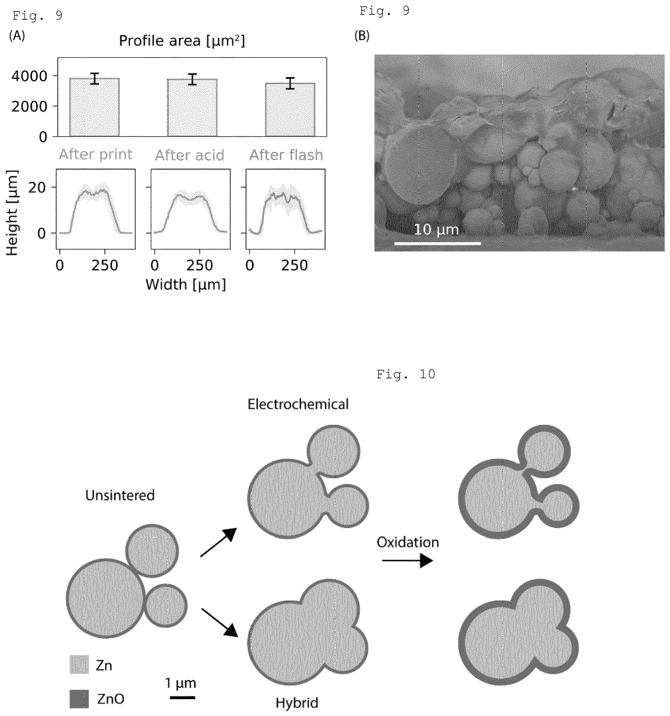

Figure 9 concerns the study on profile geometry and microstructure for sintered screen-printed traces, in particular
Fig.9A) the figure represents an area and average height of screen-printed profiles after printing, acetic acid sintering and photonic sintering;
Fig.9B) the figure represents SEM cross-section of sintered Zn on polyimide, after freezing in liquid nitrogen and cutting. The sintering and melting of particle is gradual and localized particularly in the top 5-10µm.
Figure 10 is a schematic representation of the method for the longer durability of photonic sintered Zn in air according to the present application.

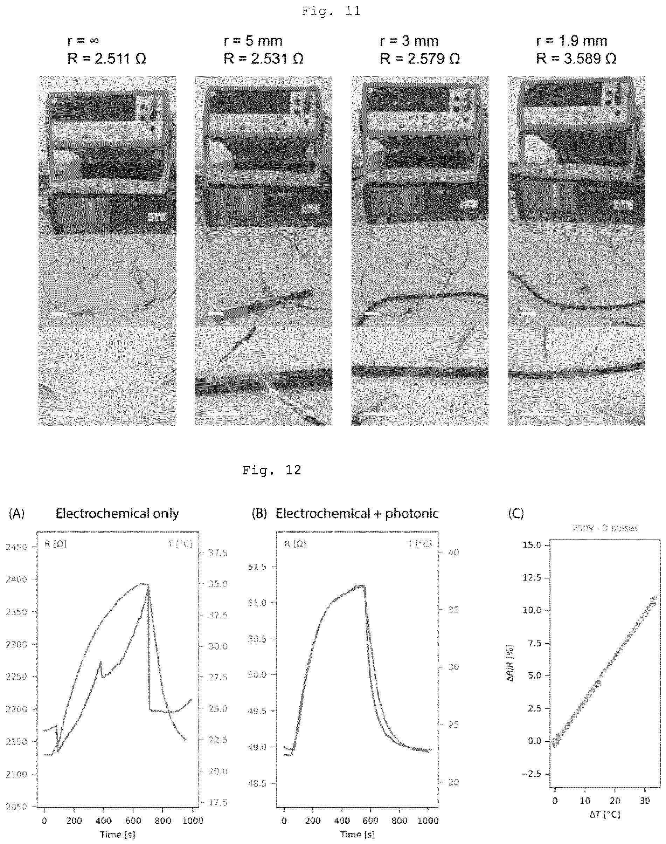

Figure 11 represents bending of a Zn resistor (50 x 0.5mm) at different bending radii.
Figure 12 represents the temperature behavior of Zn lines as a function of sintering process, wherein
   (A) represents heating and cooling of acid sintered Zn resistor.
   (B) represents heating and cooling of sintered Zn resistor according to the method of the present invention.
   (C) represents change of resistance with respect to temperature for a resistor sintered with a lamp voltage of 250V and 3 pules applied.

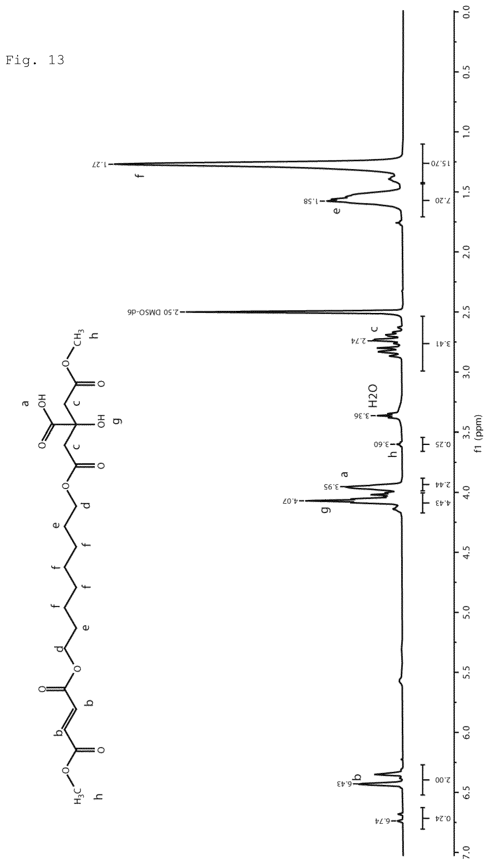

Figure 13: 1H-NMR for the synthetized POMaC pre-polymer. 1H-NMR spectra were recorded on a Bruker AVANCE-400 Ultra Shield instrument at room temperature using (CD3)2SO as solvent. 1H NMR chemical shifts are reported relative to the residual proton signal of the solvent.

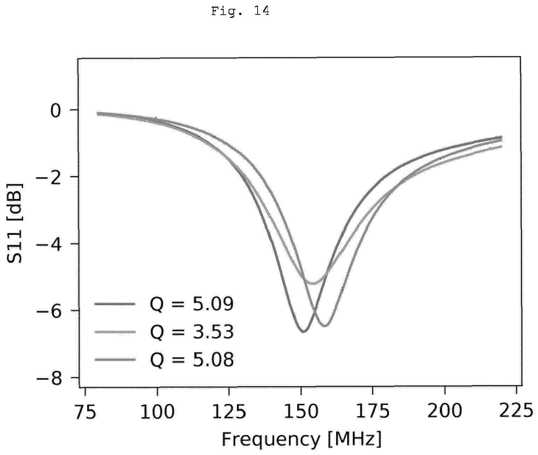

Figure 14: Return loss (S11) of typical transient wireless pressure sensors.

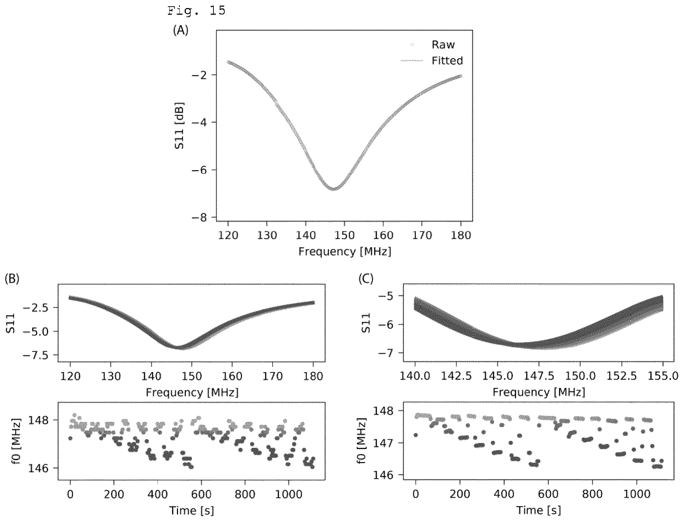

Figure 15: Real-time data processing for the S11 data of pressure sensitive wireless circuits. (A) A 5th degree polynomial fit used to smooth the resonant frequency signal. (B) The S11 signal and corresponding resonant frequency during application of a calibration force signal, without polynomial fit smoothing. (C) The same data with the polynomial fit smoothing

### Detailed description of the application

Embodiments of a method for manufacturing a metal trace 1 according to the present disclosure are hereafter described with reference to the enclosed drawings.

The metal trace is deposited in or on a substrate 3, in the form of metal micro or nanoparticles 2. The particles 2 are deposited by means of, for instance, inkjet printing. This technique is not limiting for the present invention but it is disclosed here below since it allows for low temperature thin film depositions on planar substrates, low temperatures being -among other- desirable to avoid damages to the substrate. Other deposition techniques, however, such as gravure printing, flexography printing, offset printing, stencil printing, screen printing, direct ink writing, inkjet printing, aerosol jet printing, spin-coating or slot-die coating, drop-coating, doctor blade casting, to cites some, are suitable as well for low temperature thin film depositions and may be therefore adopted in place of inkjet printing. Moreover, the micro or nanoparticles may be included in another medium such as a paste or slurry, instead of an ink, which may be deposited by means of other techniques, still suitable for low temperature thin film depositions.

As to inkjet printing in particular, the technique images a digital graphic or pattern generated by a medium by propelling ink droplets onto the substrate, such as, paper, plastic, to cite some. Different kind of substrate may be adopted for supporting the medium (the ink), such as Poly(vinyl acetate), Polylactic acid or paper, cellulose-derived, polysaccharides, synthetic polymers, PCL, sodium carboxymethyl cellulose (Na-CMC), poly(ethylene) oxide (PEO), polylactic acid (PLA), polyglycolic acid (PGA), polylactic-co-glycolic acid (PLGA), silk, poly(glycerol-sebacate) (PGS).

The medium may include a solvent and/or a polymeric binder and/or a dispersant. Various printing conducting materials may be used, as being suspended in the medium, capable of maintaining the viscosity for printing. The ink according to exemplary embodiment includes metal micro or nanoparticles, for instance zinc nanoparticle, which is used to print conductive traces on the substrate. Other metals may be used in addition or replacement of zinc nanoparticles, for instance iron or tungsten or molybdenum or magnesium or an alloy thereof. Various print heads may be used for inkjet printing the medium, including syringe, piezoelectric crystal or microelectromechanical system (MEMS) based device.

Figure 1a is a picture of the medium 2 after deposition, for instance after inkjet deposition, to form a metal trace, and figure 1c is a picture of the metal trace after a heat sintering step induced by light, according to the method of the present invention.

The drawings are not limiting as to the structure of the metal race. In this respect, for instance, the metal trace 1 may include one or more layers, although layers are not represented in the drawings. The term "layer" as used herein refers to a (usually planar) deposition of pattern corresponding to a single layer design. A layer may have one or multiple coatings of the same or different materials with the same or similar electronic properties. The term "coating" as used herein, refers to a single deposition printed in a single printing process. Multiple coatings of same or similar (electronic property-wise) material corresponding to the same layer design may be printed to increase height (thickness), to decrease resistivity of the layer, or to align two layers at the same top planar height.

The layers may be printed or coated by printing process until desired thickness thereof is obtained, or until sufficient superficial condition is obtained, or until sufficient conductivity or insulating property is obtained, however, a number of coatings or printing processes is not particularly limited.

Different layers may have various trace layouts, for instance a bottom trace layout, an insulation layer layout, a via trace layout, a top trace layout, all which are printed onto the substrate, according to the method as disclosed in the present invention, wherein typically the bottom trace layout is the one printed (deposited) directly on the substrate (for instance the paper substrate).

After printing and solvent drying (i.e. solvent in the medium dries after printing naturally on in assisted/promoted way), the metal micro or nano particles are insulated by their native oxide layer (Figure 1a). Such insulation brings to a very low conductivity of the metal trace. According to the prior art, higher conductivity in general relies on the use of flash sintering, which is indeed commonly used in the treatment of printed metallic inks. However, in particular when degradable materials are used for the substrate supporting or absorbing the ink (medium 2) composition, high temperatures have to be avoided, to avoid also damaging the materials.

On the other hand, the native oxide layer of the micro or nanoparticles has a high melting point, and melting and coalescing of the metal particles is not achieved, if the temperature reaches the melting point. Strategies to circumvent this difficulty have been proposed in the prior art but are unsatisfactory. Prior art methods rely on the use of high-power lasers or on the electrochemical interaction between -for instance- acetic acid or other acid such as propionic acid, which converts the native oxide layer to ions of metal (Zn) which redeposit between the particles, thereby forming a conductive path. This kind of electrochemical sintering, however, usually yields lower conductivity values owing to the limited bridging of the particles and the presence of binder in the layer.

According to the method of the present invention, a hybrid approach is used on the micro or nano particles of metal, wherein with the expression hybrid approach is meant application in sequence or the following phases
a) a reduction process of the micro or nano particles insulated by their native oxide layer is triggered by the deposition of a reduction agent and
b) subsequent to removal of the oxide layer from the micro on nanoparticles, a heat sintering process induced by light is applied for sintering the micro or nanoparticles and therefore forming the metal trace.

The above steps a) and b) may be implemented by means of different techniques, wherein it is provided oxygen removal by reduction and subsequent heat sintering induced by light. Example of such different techniques are given hereafter as non-limiting embodiments of the disclosure.

For instance, Figure 6 represents diagrams of pulses delivered by the PulseForge 1200 photonic sintering lamp to implement the process of heat sintering induced by light according to an embodiment of the present disclosure. Simulations of the temperature in the metal layer upon application of the light pulse is also represented in figure 6. In this particular example, an acetic acid spray has been dispensed after deposition of the Zn as a metal microparticles layer deposited by printing, wherein the acetic acid was delivered by spray-coating on the microparticles layer, for triggering the reduction process. The high intensity pulsed light has been delivered, for a duration of 30ms, and the traces was dried on a hot plate or by application of a stream of N₂.

The energy delivered in one pulse depends on the voltage supplied to a xenon lamp. The ink was composed of zinc microparticles of average size of 2µm (in diameter), polyvinylpyrrolidone (PVP) has been used as a binder and pentanol as a solvent (see in this respect also the schematic drawing in Figure 1b). In this embodiment, the ink formulation was optimized for screen or stencil printing and the use of pentanol, which is less volatile than other solvents commonly used in printable inks, to facilitate the printing process.

The concentration of the binder (PVP) in the inks (medium) as well as its chain length have an influence not only on the quality of the printed traces but also on the electrochemical sintering process.

The hybrid approach disclosed above allows for efficient sintering and the formation of a continuous zinc layer (as in the picture of Figure 1c).

The main steps of the method carried out in this embodiment, which are also in compliance with the whole disclosure of the invention, are summarized in Figure 1d:
- deposition (for instance screen printing in the picture),
- reduction (for instance spray reduction agent on the micro/nano particles) and
- heat sintering induced by light.

SEM imaging of the metal traces are reported in Figure 1e, and have been used by the Applicant to further study the microstructure of the metal (zinc) between the processing steps.

Separate particles can be clearly observed after printing (fig. 1e-i), and the acid sintering only slightly modifies the microstructure, with conductive bridges formed between particles in the order of a few hundreds of nanometers (fig. 1e-ii). Conversely, after the application of pulsed light, microparticles are shown to have melted and aggregated (fig. 1e-iii). Photonic sintering (or other heat sintering process induced by light) may also be conducted under controlled atmosphere. Figure 1g indicates the conductance values observed for stencil printed samples processed in air and in nitrogen.

The above-mentioned exemplary embodiment of the hybrid approach, which is more generally based on use of the reduction agent for removing oxide layer from particles and heat sintering induced by light for sintering the particles, is suitable for the fabrication of functional devices, both for applications in implantable bioelectronics where transience is desirable and for applications in disposable electronics. In particular, the hybrid approach, when spray-coating and photonic sintering are used, is suitable for large-area fabrication and with roll-to-roll production. In this regard, an image of an 80x80mm print on paper is shown in Figure If. As a simple visualization of the conductivity of the Zn layer and the possibility to readily integrate high-performance electronics, a wireless power receiver was fabricated (and it is represented in Figure 1h.

Spray coating is particularly suitable also to limit damage to and dissolution of the printed traces by applying only a small amount of reduction agent, for instance acidic solution. As a consequence, several coatings and drying cycles are applied to reach a plateau conductivity in the order of 1980 S/cm.

The diagram of Figure 2a schematically represents reduction in improvements in resistance after 5-6 cycles of spray coating with the reduction agent. Moreover, the electrochemical sintering process happens on a short timeframe, and the applicant observed that fast drying was critical to avoid damage to the metal traces from prolonged exposure to the aqueous solution. This was confirmed when the conductivity was measured for several traces after each spray treatment cycle (Figure 2b). The conductivity obtained with the spray treatment is comparable with results previously known from prior art electrochemical methods.

The hybrid process is further studied with screen-printed zinc resistors (Figure 2c) sintered under inert atmosphere. It was noted that the timing between the spray coating and the photonic sintering is of importance. However, a precise study on its influence has to be made in dependance on the exact drying conditions, environment as well as the thickness and porosity of the layer, and therefore it is herein omitted.

It has been observed, however, that after approximatively one hour after the oxide reduction process, the conductivities obtained after flash sintering started to decline, and hypothesized that residual acidic solution in the metallic microparticles layer is critical to avoid re-oxidation. The conductivities obtained reach values as high as 5.62 x 10⁴ S/cm, when 3 pulses of 6559 mJ/cm² are delivered. This is likely the highest conductivity value observed for printed zinc sintering (see Figure 8). The values obtained for the highest energy (7299 mJ/cm²) are not considered as the energy was high enough to cause partial destruction of the resistors.

The energy used in one cycle of treatment is lower than in other methods where laser or photonic sintering is used to coalesce Zn particles. In order to verify that the resolution of the traces is maintained, the area of the lines was compared between each treatment step (Figure 9) and no significant difference has been observed. If the process is conducted under a nitrogen atmosphere, several pulses can be delivered to the sample to increase microparticles cohesion. The effect of a multi-pulse treatment is shown in Figure 2d.

Experiments presented in Figure 2 were conducted on polyimide, to study the heat sintering induced by light process without consideration of the substrate's influence. The process is also compatible with temperature sensitive substrates, owing to the use of flash sintering which allows to selectively heat the metal tracks with minimal energy being directly transferred to the transparent polymeric substrates.

The results of zinc hybrid sintering on two biodegradable polymers, poly(vinyl acetate) (PVA) and polylactic acid (PLA), are shown in Figure 3a. The degradable polymer layers used are thin (70 µm and 90 µm for the PLA and PVA respectively) and they remained attached to silicon wafers for the sintering process, in order to avoid local deformation around the metal traces and facilitate further steps such as encapsulation.

Experiments for samples on PLA were conducted to assess the durability of the zinc traces in conditions reproducing the operating environments in the case of biodegradable electronics (e.g. for smart packaging or environmental monitoring) and the case of bioresorbable electronics (e.g. smart implants for post-surgical monitoring).

In following experiments, when specified, the conductive Zn traces were encapsulated with 30pm of PLA by blade casting. Ideally, transient electronic devices would display stable function during their time of operation and rapid degradation upon introduction of a specific stimuli or at the end of the desired lifecycle. In air at ambient conditions (Figure 3b), the Zn traces that were fabricated with hybrid sintering and without encapsulation show stable conductivity for the period of measurement (31 days) and a 41% increase in resistance on average.

In the case of samples that were only sintered electrochemically, the conductivity of the Zn traces changes in a non-linear way after about a week, and a 90% decrease in conductivity is already attained after 300 to 500h of exposure to ambient air.

This difference can be explained by the increased aggregation of particles in the case of hybrid sintering according to the method of the present invention. In the case of electrochemical sintering, the bridges formed between particles are naturally converted back to ZnO, reducing conductivity of the layer (Figure 10).

The printed Zn lines were also tested for flexibility with repeated bending tests (Figure 3c). In the case of inks that are sintered fully at room temperature, the binder content may have an influence of the flexibility of the pattern. In case flash sintering is employed however, PVP is likely vaporized, and does not contribute to rendering the metal traces more flexible. Nonetheless, the hybrid sintered Zn patterns can be bent down to a radius of 3mm without loss in conductivity (Figure 11). Encapsulated samples exhibit better resilience to repeated bending, as the neutral plane is shifted closer to the metal line, and the polymeric encapsulation also likely reinforces the porous metallic layer.

In the case of encapsulated samples bent at a radius of 10mm, the resistance increases by 9% after 1000 cycles at 0.5Hz. As mentioned above, the durability of sintered Zn lines was assessed in phosphate-buffered solution (PBS) at 37°C to emulate in vivo physiological conditions. The connections with the measurement setup were encapsulated in epoxy and sealed outside of the vial with roomtemperature vulcanizing silicone (RTV 734). Unencapsulated zinc traces disintegrate rapidly in aqueous medium and the conductivity degrades by an order of magnitude within 46.6h on average. With a 30pm-thick encapsulation, the resistance gradually increases, due to the slow diffusion of water across the polymeric encapsulation and the same loss of conductivity as for the unencapsulated samples is observed on average after 28 days in solution.

The flexibility, stability and enhanced sintering of the printed zinc can be leveraged to fabricate simple transient resistive sensors. Figure 4a shows a resistive strain sensor undergoing repeated bending in compression and in tension. The resistance value varies by approximatively ±0.2% and returns to baseline value upon release of the sensor. The temperature behavior of the zinc degradable resistors was studied with the aim of fabricating resistance thermometers (Figure 12).

As for the durability in air, the stability under higher temperatures is improved by the photonic sintering step (or other heat sintering induced by light) with respect to only electrochemical sintering. The temperature coefficient of resistance (TCR) of the printed zinc after hybrid sintering was estimated to be 0.003157 °C⁻¹, which is close to the TCR of bulk zinc (0.003847 °C⁻¹). Figure 4b shows such a temperature sensor in PBS, where the temperature in the solution is controlled by a hot plate and a reference provided by a commercial temperature sensor (Sensirion) which was encapsulated in epoxy resin. The change in resistance of two sensors is shown for variations of temperature around 37°C in respectively Figure 4c and Figure 4d.

The combination of stencil printing and two-step sintering can also be used to create more complex device architectures, as those shown in Figure 5. Transient capacitive pressure sensors relying on a soft bioresorbable elastomer poly(octamethylene maleate (anhydride) citrate) (POMaC) as dielectric layer are presented. The POMaC pre-polymer was synthetized and an exemplary ¹H-NMR spectrum is shown in Figure 13. A simple fabrication process was chosen, which leverages the dual cross-linking mechanism of POMaC. As shown in Figure 5a, the metallic plates and contact pads for the capacitive sensors were printed and treated on PLA, and POMaC pre-polymer was deposited by blade casting. The pre-polymer was cured by ultraviolet (UV) photopolymerization, yielding a solid but tacky polymeric layer. The assembly was then folded with the POMaC layer on the inside and further allowed to cure and bond at 80°C for 48h. The sensors were tested for forces up to 10N and the response in capacitance followed the applied force closely and maintained a stable baseline (Figure 5b). The device shown here had an initial capacitance of 20.42pF and the change in capacitance was linear with the force applied, with a sensitivity of 71.4fF/N (Figure 5c). The device was also tested under cycling conditions for 2500 cycles of a duration of 40 seconds and an amplitude of 4N (Figure 5d). The maximal value of capacitance recorded during the cycling varied by 0.36% and the baseline by 0.27%. Bioresorbable electronic sensors are envisaged for applications in post-operative monitoring or regeneration, and while transient metal cables and connections can be used to interface with them, wireless powering and communication are a desirable option to minimize invasiveness. Therefore, a similar design with a zinc coil in series was fabricated (Figure 5d), relying on the same folding process. The sensing relies on the shift in resonant frequency of the series RLC circuit formed by the Zn-POMaC capacitive element characterized above and the Zn antenna. Figure 14 shows the return loss (S11) of typical devices as measured with a custom-made silver antenna on FR4. The response is comparable to the soft capacitors shown above, with a shift in frequency proportional to the applied force (Figure 5e).

Hereafter, experiments carried out are briefly disclosed and commented.

Zn-based inks have been prepared as follows as a preparatory step, in order to subsequently deposit the Zn-based inks on a substrate. Zn microparticles of 2 µm as an average diameter (from Sigma Aldrich), polyvinylpyrrolidone (Sigma Aldrich, Mw=360K or 2000K) and Pentanol (Sigma Aldrich) were mixed at varying weight ratios (25:1:5 for the final formulation). The ink was homogenized with a planetary mixer (Thinky ARE-250) at 300 rpm for 30 minutes. It was stored at 4°C and brought to room temperature and homogenized at 300 rpm for 10 minutes before printing.

Substrates and encapsulation layer have been prepared as follows: The substrates are polyimide (DuPont, Kapton^{®} 125 µm), biodegradable paper (Arjo-Wiggins Powercoat XD, 200 µm), polylactic acid (Ingeo^{™} Biopolymer 4032D) and polyvinyl alcohol (Sigma-Aldrich, Mowiol 4-88). For the preparation of PLA films, pellets were dissolved in 1,4 dioxane (Sigma-Aldrich) overnight at 50°C under stirring to obtain a 15 wt% solution. Films of PLA were prepared by blade-casting the solution on a a standard 4-inch single side polished silicon wafer at a speed of 2 mm/s with a gap of 1000 µm to obtain films of 70 µm in thickness, after overnight drying. 25 wt% solutions of PVA were prepared by dissolving PVA for 3h in DI water under stirring. The PVA films were cast as described above, with a gap of 600 µm to obtain films with a thickness of 75 µm. Before printing the Zn traces, all substrates, except the paper, were first activated with an oxygen plasma treatment for 5mn at 200 W and 40 kHz (Diener). For the encapsulation of the sintered Zn traces, the same PLA solution was blade-casted with a gap of 500 µm, to yield an encapsulation of approximately 35 µm in thickness.

Printing the Zn traces was made as follows. In a first experiment, stencil printing was used. One-sided polyethylene adhesive tape (Nexus G20, 80 µm) was cut with the desired patterns with a CO₂ laser (Trotec Speedy300). The Zn ink was applied with a silicone squeegee and left to dry for 1 hour, after which the stencil was peeled off from the substrate. Another experiment was made with screen printing. Custom stainless steel meshes (Serilith) were used, and the ink was applied through the stencil with a silicone squeegee, at a distance of 500 µm from the substrate. The traces were left to dry for one hour before further processing.

Subsequently, Zn traces have been treated. Acetic acid (10 vol% in deionized water) was spray-coated on the Zn traces using an airbrush (0.2 mm nozzle, at a distance of approximatively 10 cm from the substrate) supplied by 2 bar N₂ pressure, followed by 2 minutes drying under nitrogen. This spray-coating/drying cycle was repeated for a total of 5 times. In the case where the process atmosphere was controlled, the samples were placed in a custom chamber which was purged with nitrogen for 30 seconds. The photonic sintering treatment (Novacentrix PulseForge 1200) comprised pulse energies ranging from 3107 to 12867mJ/cm² and between 1 and 6 pulses were delivered.

The following material characterization have been observed on the Zn metal traces so realized. The thickness and morphology of the printed Zn patterns were characterized using a laser scanning confocal microscope (Keyence VK-X1000). The microstructure of the traces with different treatments was inspected by SEM (JEOL JSM-7500TFE). The resistance of the Zn lines was measured using a tabletop multimeter (Keysight 34401A). In order to avoid contact resistance effects, 4-wire measurements were performed with custom Kelvin probes. For bending tests, Zn lines were stencil-printed, encapsulated as described above if required, the outline of the samples was laser-cut and the samples were peeled off from the silicon wafer. A custom setup consisting of clamps and a linear motor was used. For the degradation tests, Zn lines were fabricated as described above and soldered to the pads of ZIF connectors using silver epoxy (Epotek E4110). The connection was encapsulated in epoxy resin and the samples were released and placed in phosphate-buffered saline at 37°C, while the resistance values were measured with a data logger switching unit (Keysight 34970A).

Temperature coefficient of resistance measurements: Zn resistors were patterned by screen printing and sintered using the two-step process presented above. The resistance was monitored continuously with a digital multimeter (Keysight 34401A), and reference temperature was acquired using a commercial sensor (Sensirion SHT4x). The temperature was varied in a custom-made chamber (or a plastic vial in the case of experiments conducted in PBS) with the help of a hot plate.

Pressure sensors fabrication and characterization: The different designs for the pressure sensors were printed with a laser-cut stencil and treated with the aforementioned sintering process. POMaC was synthesized as previously described. Maleic anhydride, citric acid and 1,8 octanediol (all from Sigma-Aldrich) were mixed at a molar ratio of 3:2:5 in a three-necked flask. The mixture was heated to 160°C (under nitrogen flow and 200 rpm stirring) until the reagents were fully melted and then reacted at 140°C for 3 hours. The pre-polymer was dissolved in THF and purified by drop-wise purification in DI water, decanted and dried. The pre-polymer was mixed with 5 wt% of the photonitiator Irgacure 2959. The POMaC pre-polymer/photoinitiator mixture was then blade-cast with a gap of 500 µm and a speed of 3 mm/s and cured under UV (Proma 140001, 60 W, 365 nm) for 20 minutes. The outlines of the sensors were then cut with a laser engraver (Trotec Speedy 300), they were then gently peeled from the silicon wafer, folded and cured at 80°C for 48h. Uniaxial pressures were applied with a pull-tester (Instron 3340) and the capacitance values were recording using an LCR-meter (E4980A) at 2MHz. In the case of the wireless Zn sensors, the S11 coefficient was measured with a vector network analyzer (NanoVNA V2) with the aid of a custom-made reader coil (silver on FR4). The resonant frequency of the sensor was extracted with a custom script algorithm.

Wirelessly powered circuit: A similar fabrication process to the one described above for the wireless pressure sensors was used. POMaC was used as a bonding layer and was separately blade-cast on a silicon wafer with a polyacrylic acid sacrificial layer. The POMaC was cured under UV, laser cut, released in DI water and laminated on the bottom half of the PLA coil. The top half was limited onto the POMaC layer after filling the vias with silver epoxy, and the assembled sensor was cured at 80°C for 48h for allow the POMaC to fully polymerize. Finally, the SMD components (green LED and 470 pF capacitor) were connected to the Zn lines using the Zn ink described above mixed with 10 vol% acetic acid.

Advantageously, the method of manufacturing electrically conductive metal trace or (track) according to the present invention allows production on a large scale, avoiding manual steps, support production of traces overcome limit in thickness which affects the other known processes, improve the conductivity, strength, while limiting the quantity of energy used for manufacturing, and without stressing the trace or the substrate.

Due to these advantages, the method of manufacturing may be used to enable the fabrication of passive high-frequency, long-range antennas that are suitable for the use in smart packaging applications, for the tracking of parameters such as temperature, humidity, and for identification purposes. Moreover, three-dimensional structures suitable, for instance, for personalized transient medical implants including the metal traces may be manufactured. Zinc sintering technology in conjunction with organic polymers according to the method for manufacturing of the present invention, moreover, is also suitable for the creation of degradable biosensors that can detect various bioanalytes. Degradable components for eco-friendly electronics, in applications where temporary function is acceptable or even desirable, may therefore effectively manufacture. The metal traces produced by the method of the invention may be widely used for packaging, whether of food products, sensitive chemicals or medical drugs. Packaging represents nearly one-third of total waste produced and 40% of produced plastic goes toward packaging, which is used once and then incinerated. Thanks to recyclable packaging solution based on transient metal tracks of the present invention, new smart packaging solutions may be adopted.

## Claims

1. Method for manufacturing an electrically conductive metal trace (1) comprising
- depositing metal micro or nano particles (2) in or on a substrate (3);
- removing an oxide layer (4) around the particles;
- sintering the particles after oxide layer removal to form the electrically conductive metal trace (1);
**characterized in that**
- said step of removing the oxide layer is an electrochemical process wherein the metal micro or nano particles are contacted by a reducing agent (5), and
- wherein in said step of sintering heat is induced by light (6).

2. Method according to claim 1 wherein the micro or nanoparticles are included in a paste, ink or slurry.

3. Method according to claim 1 wherein the metal of the micro or nano particles includes zinc and/or iron and/or tungsten and/or molybdenum and/or magnesium and/or an alloy thereof.

4. Method according to claim 1 wherein depositing the metal micro or nano particles is made by gravure printing and/or flexography printing and/or offset printing and/or stencil printing and/or screen printing and/or direct ink writing and/or inkjet printing and/or aerosol jet printing and/or spin-coating and/or slot-die coating and/or drop-coating and/or doctor blade casting.

5. Method according to claim 1 wherein the substrate includes at least one of Poly(vinyl acetate), Polylactic acid or paper, cellulose-derived, polysaccharides, synthetic polymers, biopolymers, Si, glass, polyhydroxyalkanoates, polyesters, polyanhydrides, PCL, sodium carboxymethyl cellulose (Na-CMC), poly(ethylene) oxide (PEO), polylactic acid (PLA), polyglycolic acid (PGA), polylactic-co-glycolic acid (PLGA), silk, poly(glycerol-sebacate) (PGS).

6. Method according to claim 1 wherein the substrate and/or the metal is biocompatible and/or bioresorbable.

7. Method according to claim 1 wherein said sintering induced by light includes photonic sintering and/or flash sintering and/or intense pulsed light sintering and/or laser sintering and/or UV sintering.

8. Method according to claim 1 wherein said reducing agent is applied on the paste, ink or slurry after the paste, ink or slurry have been deposited on the substrate.

9. Method according to claim 1 wherein the paste, ink or slurry includes the reducing agent as a component, and wherein the reducing agent is mixed to other components of the paste, ink or slurry before or during deposition.

10. Method according to claim 1 wherein the reducing agent is applied by spraying and wherein the particles are dried after spraying.

11. Method according to claim 10 wherein drying includes flowing air, and/or an inert gas and/or heating at a temperature between 20° and 200°, preferably between 25° and 60°, preferably under an inert gas atmosphere.

12. Electrically conductive circuit including at least one metal trace in or on a substrate, produced by a method of any one of the claims from 1 to 11.

13. Electrically conductive circuit according to claim 12, wherein the substrate and/or the metal trace are biodegradable or bioresorbable, preferably upon application of an internal or external stimulus which triggers a change of the electric conductive circuit from a first functionally operable state to a second functionally inoperable state.

14. Electrically conductive circuit according to claim 12, wherein the at least one metal trace has a thickness comprised between 20 nm and 200 µm.

15. Electrically conductive circuit according to claim 12, wherein the at least one metal trace has a length included between 100 nm and 1 m, and a surface of the layer is between 100 µm² and 100 cm².
